# EUROPÄISCHE PATENTANMELDUNG

(11) **EP 1 429 461 A1**
(43) Veröffentlichungstag der Anmeldung: **16.06.2004**
(21) Anmeldenummer: 03027885.7
(22) Anmeldetag: 04.12.2003
(51) Int. Cl.: H03K 17/0814, H02M 3/335

(54) **Getaktete Leistungsversorgung**

(30) Priorität: 11.12.2002 DE 10257908
(71) Anmelder: Patent-Treuhand-Gesellschaft für elektrische Glühlampen mbH, 81543 München (DE)
(72) Erfinder: De Anna, Paolo, 31039 Riese Pio X (TV) (IT); Francescutti, Ugo, 31050 Ponzano Veneto (TV) (IT)

(57) **Zusammenfassung**

Getaktete Leistungsversorgung mit einer Serienschaltung aus einem elektronischen Schalter (T1) und der Primärwicklung (W1) eines Transformators (TX1). Die Leistungsversorgung besitzt außerdem eine Schaltentlastungseinrichtung in der beim Ausschalten des elektronischen Schalters (T1) die Energie der Primärwicklung (W1) in einem Kondensator (C1) gespeichert wird. Erfindungsgemäß besitzt die Schaltentlastungseinrichtung einen weiteren elektronischen Schalter (D1, T2), der solange eingeschaltet bleibt, bis die im Kondensator (C1) gespeicherte Energie wieder in den Transformators (TX1) zurückgespeist ist.

## Beschreibung

### Technisches Gebiet

Die Erfindung betrifft eine getaktete Leistungsversorgung gemäß dem Oberbegriff des Anspruchs 1. Getaktete Leistungsversorgungen werden im folgenden kurz Leistungsversorgung genannt. Im wesentlichen behandelt die Erfindung eine Leistungsversorgung mit einer Schaltentlastungseinrichtung. Die Leistungsversorgung ist zum Betrieb von Lichtquellen geeignet.

### Stand der Technik

Leistungsversorgungen, wie sie z. B. aus Mohan, Undeland, Robins: "Power Electronics", John Wiley & Sons, 1995, New York, USA, Chapter 7 und 10 bekannt sind besitzen mindestens einen elektronischen Schalter. Beim Schaltvorgang dieser Schalter entstehen Schaltverluste, die durch Schaltentlastungseinrichtungen reduziert werden können. Einen Überblick über derartige Schaltentlastungseinrichtungen gibt z. B. folgende Literatur: Philip C. Todd: "Snubber Circuits: Theory, Design and Application" im Power Supply Design Seminar Manual, UNITRODE, Merrimack, NH, USA, 1993. Darin wird zwischen dissipativen und nicht-dissipativen Schaltentlastungseinrichtungen unterschieden.

Dissipative Schaltentlastungseinrichtungen sind mit wenig Aufwand zu realisieren. Ihr Nachteil ist jedoch, dass sie hohe Verluste bewirken und starke Störschwingungen anregen können. Die Verluste reduzieren den Wirkungsgrad des Schaltnetzteils und die Störschwingungen verursachen Funkstörungen.

Eine nicht dissipatives Entlastungsnetzwerk für einen Gleichstromsteller ist in der Schrift EP 0 798 857 (Osterried) beschrieben. Es enthält mindestens 2 Dioden und eine Drossel. Insbesondere die Drossel bedeutet einen hohen Aufwand bei der Realisierung des Entlastungsnetzwerks.

### Darstellung der Erfindung

Es ist Aufgabe der vorliegenden Erfindung, eine Leistungsversorgung gemäß dem Oberbegriff des Anspruchs 1 bereitzustellen, das eine Schaltentlastungseinrichtung aufweist, die mit geringem Aufwand realisierbar ist, wenig Verlustleistung produziert und wenig Störschwingungen anregt.

Diese Aufgabe wird durch eine Leistungsversorgung mit den Merkmalen des Oberbegriffs des Anspruchs 1 durch die Merkmale des kennzeichnenden Teils des Anspruchs 1 gelöst. Besonders vorteilhafte Ausgestaltungen finden sich in den abhängigen Ansprüchen.

Die Erfindung geht aus von einer Leistungsversorgung mit einem Transformator, der eine Primär- und eine Sekundärwicklung besitzt. Die Sekundärwicklung ist mit einer Last verbindbar. Der Transformator kann mehrere Sekundärwicklungen besitzen, wobei jede Sekundärwicklung jeweils mit einer Last verbindbar ist.

Im allgemeinen kann jeder elektrische Verbraucher eine Last darstellen. Insbesondere ist die Erfindung jedoch geeignet, um eine Netzspannung von beispielsweise 230Veff in eine Gleich- oder Wechselspannung unter 50V zu transformieren. Damit können dann z.B. elektronische Geräte betreiben werden.

Aufgrund der hohen Anforderungen an Verlustleistung und Funkstörungen in der Beleuchtungstechnik, ist die Erfindung besonders zum Betrieb von Lichtquellen geeignet. Glühlampen, Leuchtdioden oder sog. OLEDs (Organic Light Emission Device) können dabei beispielsweise zum Einsatz kommen. Beim Betrieb von Leuchtdioden ist es vorteilhaft, die an der Sekundärwicklung bereitgestellte Wechselspannung gleichzurichten und zu glätten.

Weiterhin geht die Erfindung davon aus, dass die Leistungsversorgung einen ersten und ein zweiten Energieeinspeisepunkt besitzt. Diese sind zum Einspeisen einer Speisegleichspannung vorgesehen. Die Speisegleichspannung kann beispielsweise von einer Batterie oder durch Gleichrichtung und Glättung einer Netzspannung bereitgestellt werden.

Weiterhin geht die Erfindung davon aus, dass ein erster elektronischer Schalter in Serie zur Primärwicklung geschaltet ist. Die so entstandene Serienschaltung ist mit dem ersten und dem zweiten Energieeinspeisepunkt gekoppelt. Wird der erste elektronische Schalter geschlossen, so bewirkt die Speisegleichspannung einen ansteigenden Strom in der Primärwicklung. Dieses Prinzip ist in vielen Topologien für getaktete Leistungsversorgungen verwirklicht. Beschrieben sind sie in der oben genannten Literaturstelle (Mohan, Undeland, Robins: "Power Electronics", John Wiley & Sons, 1995, New York, USA, Chapter 7 und 10). Verbreitet ist der sog. Sperrwandler oder Flyback, da diese Topologie bei kleiner Leistung (bis 100W) kostengünstig realisiert werden kann.

Nach einer vorgegebenen Zeit wird der erste elektronische Schalter wieder abgeschaltet. Durch diesen Abschaltvorgang kann der in der Primärwicklung aufgebaute Strom nicht weiter durch den ersten elektronischen Schalter fließen. Steht keine Schaltentlastungseinrichtung vor Verfügung, so baut sich an Arbeitsanschlüssen des ersten elektronischen Schalters eine hohe Spannung auf, die hohe Verluste im ersten elektronischen Schalter zur Folge hat und zu dessen Zerstörung führen kann.

Weiterhin geht die Erfindung davon aus, dass die Leistungsversorgung eine Schaltentlastungseinrichtung enthält. Die Schaltentlastungseinrichtung enthält mindestens die Serienschaltung aus einem Kondensator und einem zweiten elektronischen Schalter.

Weiterhin geht die Erfindung davon aus, dass die Schaltentlastungseinrichtung so in der Leistungsversorgung verschaltet ist, dass die Energie, die beim Abschalten des ersten elektronischen Schalters durch den Strom in der Primärwicklung repräsentiert wird, zumindest teilweise vom Kondensator aufgenommen wird.

Da im Stand der Technik der zweite elektronische Schalter als schnelle Diode ausgeführt ist, kann die vom Kondensator aufgenommenen Energie nicht mehr über den zweiten elektronischen Schalter abfließen. Es muss im Stand der Technik deshalb Sorge dafür getragen werden, dass der Kondensator bis zum nächsten Ausschaltvorgang entladen wird. Dies geschieht im Stand der Technik über einen ersten Widerstand, der einen Entladestrompfad für den Kondensator bereitstellt. Die im Kondensator gespeicherte Energie wird im ersten Widerstand in Verlustleistung umgewandelt. Wird für den ersten Widerstand ein großer Wert gewählt, kommt es zu Schwingungen der an den Arbeitsanschlüssen des ersten elektronischen Schalters anliegenden Spannung. Diese können Funkstörungen verursachen.

Wie oben beschrieben wird für den zweiten elektronischen Schalter im Stand der Technik einen schnelle Diode verwendet. Die Schnelligkeit einer Diode wird im allgemeinen durch eine Rückwärtserholzeit beschrieben. Wird nach einer Zeit, in der die Diode von einem Strom in Flussrichtung durchflossen wurde, die Stromrichtung umgedreht, so fließt während der Rückwärtserholzeit ein Strom in Sperrrichtung durch die Diode. Die Rückwärtserholzeit bei Dioden nach dem Stand der Technik ist so kurz, dass sich der Kondensator während der Rückwärtserholzeit nur unwesentlich entladen kann.

Erfindungsgemäß bewirkt der zweite elektronische Schalter, dass ein wesentlicher Teil der vom Kondensator aufgenommenen Energie in den Transformator zurückgespeist wird.

Nachdem die Energie, die durch den Strom in der Primärwicklung des Transformators beim Abschalten des ersten elektronischen Schalters repräsentiert wird, abgebaut ist, ist der Strom in der Primärwicklung, nachdem er zuvor in eine positive Richtung floss, auf Null abgesunken. Eine Diode nach dem Stand der Technik verhindert einen Anstieg des Stroms in die negative Richtung. Ein erfindungsgemäßer zweiter elektronischer Schalter lässt einen Strom in die negative Richtung zu. Dies, solange, bis die im Kondensator gespeicherte Energie in Form eines Stroms in der Primärwicklung in den Transformator zurückgespeist wurde. Ein Grossteil der zurückgespeisten Energie gibt der Transformator über seine Sekundärwicklung an die Last ab. Vorteilhaft wird dadurch in der Leistungsversorgung nur wenig Verlustleistung erzeugt.

Weiterhin vorteilhaft ist, dass der Schwingkreis, der durch die Primärwicklung und den Kondensator gebildet wird, durch die Last gedämpft wird. Damit werden Störschwingungen unterdrückt.

### Kurze Beschreibung der Zeichnungen

Im folgenden soll die Erfindung anhand von Ausführungsbeispielen unter Bezugnahme auf Zeichnungen näher erläutert werden. Es zeigen:
- Figur 1: ein erfindungsgemäßes Ausführungsbeispiel einer Leistungsversorgung,
- Figur 2: den zeitlichen Verlauf der Spannung an den Arbeitsanschlüssen des ersten elektronischen Schalters nach dem Stand der Technik,
- Figur 3: den erfindungsgemäßen zeitlichen Verlauf der Spannung an den Arbeitsanschlüssen des ersten elektronischen Schalters,
- Figur 4: ein weiteres erfindungsgemäßes Ausführungsbeispiel einer Leistungsversorgung
- Figur 5: ein weiteres erfindungsgemäßes Ausführungsbeispiel einer Leistungsversorgung

Im folgenden werden Widerstände durch den Buchstaben R, Transistoren durch den Buchstaben T, Dioden durch den Buchstaben D, Kondensatoren durch den Buchstaben C jeweils gefolgt von einer Zahl bezeichnet. Auch werden im folgenden für gleiche und gleichwirkende Elemente der verschiedenen Ausführungsbeispiele durchweg gleiche Bezugszeichen verwendet.

### Bevorzugte Ausführung der Erfindung

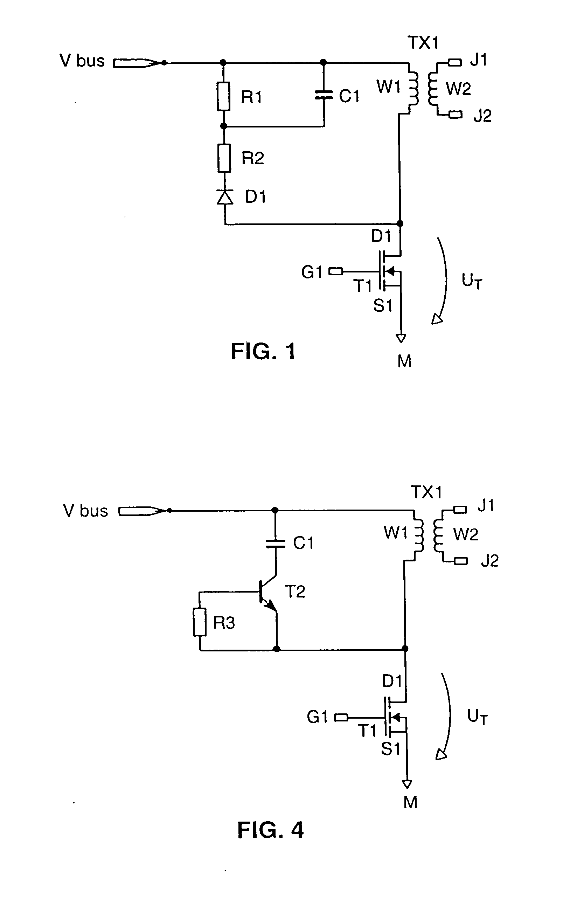

In Figur 1 ist ein erfindungsgemäßes Ausführungsbeispiel einer Leistungsversorgung dargestellt. An einem Anschluss Vbus ist bezüglich eines Bezugspotenzials M eine Speisegleichspannung anschließbar. Zwischen den Anschluss Vbus und das Bezugspotenzial M ist die Serienschaltung der Primärwicklung W1 eines Transformators TX1 und ein erster elektronischer Schalter geschaltet, der durch einen N-Kanal MOSFET T1 realisiert ist. Es ist auch eine Realisierung durch andere elektronische Schalter wie z. B. IGBT, bipolare Transistoren oder P-Kanal MOSFET möglich. Der Drainanschluss D1 von T1 bildet einen Arbeitsanschluss von T1 und ist mit der Primärwicklung W1 verbunden. Der Sourceanschluss S1 von T1 ist mit dem Bezugspotenzial M verbunden. Der Gateanschluss G1 von T1 ist mit einer nicht dargestellten Steuerschaltung verbunden. Die Steuerschaltung sorgt dafür, dass T1 entsprechend den Anforderungen, die an die Leistungsversorgung gestellt werden, ein- und ausgeschaltet wird.

Die Serienschaltung von T1 und der Primärwicklung W1 ist so gewählt, dass T1 mit dem Bezugspotenzial M verbunden ist. Dies hat den Vorteil, dass die Steuerschaltung ein Signal bereitstellen muss, das auch auf das Bezugspotenzial M bezogen ist. Der Aufwand in der Steuerschaltung kann damit gering gehalten werden. Es ist aber auch möglich, in der Serienschaltung die Primärwicklung W1 und T1 zu vertauschen, so dass die Primärwicklung W1 mit dem Bezugpotenzial M verbunden ist.

Die Sekundärwicklung W2 des Transformators TX1 besitzt zwei Anschlüsse J1 und J2, an die eine Last anschließbar ist.

Parallel zur Primärwicklung W1 ist die Serienschaltung eines ersten Widerstands R1, eines zweiten Widerstands R2 und eines zweiten elektronischen Schalters geschaltet. Der zweite elektronische Schalter ist als Diode D1 ausgeführt ist, die so gepolt ist, dass sie einen Stromfluss vom Anschluss Vbus zum Bezugspotenzial M sperrt.

Parallel zum ersten Widerstand R1 ist ein Kondensator C1 geschaltet.

Zwischen dem Drainanschluss D1 und dem Sourceanschluss S1 ist eine Spannung zwischen den Arbeitsanschlüssen des Transistors UT gekennzeichnet.

Ist T1 geschlossen, so führt die Speisegleichspannung zu einem positiven Strom durch die Primärwicklung W1. Schaltet T1 ab, so fließt dieser Strom weiter durch D1 und lädt den Kondensator C1 bis der Strom auf den Wert Null abgesunken ist. Der zweite Widerstand R2 begrenzt den Strom durch D1. Dies kann für eine kostengünstige Auswahl von Bauelementen wichtig sein. Der Wert des zweiten Widerstands kann aber auch Null sein. Da R2 auch eine Dämpfung des durch die Primärwicklung W1 und C1 dargestellten Schwingkreises bewirkt, kann bei einem Wert Null für R2 ein gegebenes Limit für Störschwingungen überschritten sein. In diesem Fall muss der Wert für R2 soweit erhöht werden, bis das gegebene Limit für Störschwingungen eingehalten wird.

Erfindungsgemäß besitzt D1 nun eine Rückwärtserholzeit, die. einen negativen Stromfluss durch die Primärwicklung zulässt. Die Rückwärtserholzeit ist so groß, dass eine vollständige Entladung von C1 erfolgt. Der Großteil der in C1 gespeicherten Energie wird somit über den Transformator an die Last abgegeben. Nur ein unwesentlicher Bruchteil wird im ersten Widerstand R1 dissipiert. R1 dient dazu Störschwingungen, die trotz einer erfindungsgemäßen Auslegung von D1 noch in geringem Maße auftreten, weiter zu dämpfen. Der erste Widerstand R1 kann aber auch entfallen.

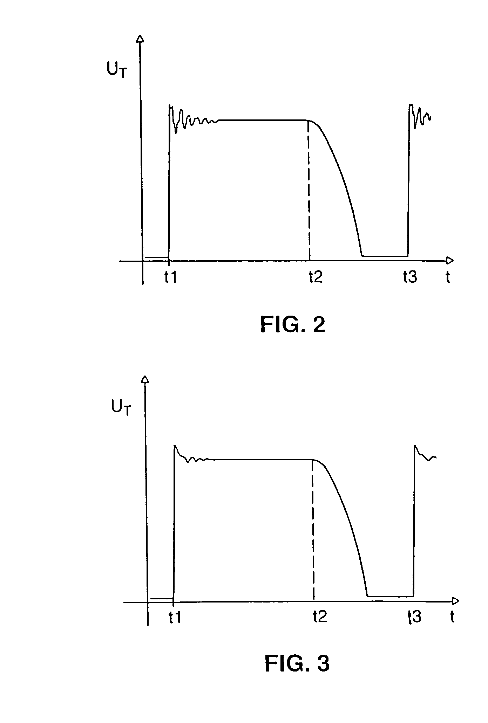

In Figur 2 ist der Verlauf der Spannung UT aus Figur 1 über der Zeit t dargestellt, jedoch für eine Auslegung für D1, die dem Stand der Technik entspricht. Zum Zeitpunkt t1 schaltet T1 ab und die Spannung UT steigt schnell an. Der Wert der Spannung UT ist zwar durch die Schaltentlastungseinrichtung begrenzt jedoch erkennt man deutlich eine Störschwingung, die durch den Ausschaltvorgang ausgelöst wird. Nach dem Abklingen der Störschwingung stellt sich die Spannung UT auf einen Wert ein, der der Summe der Speisegleichspannung und der in die Primärwicklung W1 transformierten Ausgangsspannung an der Sekundärwicklung W2 entspricht. Beim Betrieb an einer Netzspannung kann dieser Wert beispielsweise zwischen 100V und 350V liegen. Die Frequenz der Störschwingung liegt typischerweise im MHz-Bereich.

Zum Zeitpunkt t2 schaltet T1 wieder ein und die Spannung UT sinkt wieder auf vernachlässigbare Werte ab. Bei Leistungsversorgungen, die zum Betrieb von Leuchtdioden an einer Netzspannung geeignet sind, liegt zwischen den Zeitpunkten t1 und t2 beispielsweise ein Zeitintervall von 5 Mikrosekunden. Zum Zeitpunkt t3 schaltet T1 erneut ab und der beschriebene Vorgang wiederholt sich periodisch. Die Periodendauer im o.g. Anwendungsfall beträgt beispielsweise 8 Mikrosekunden.

In Figur 3 ist der Verlauf der Spannung UT aus Figur 1 über der Zeit t dargestellt, wie er sich bei einer erfindungsgemäßen Auslegung der Rückwärtserholzeit von D1 ergibt. Die Amplitude der Störspannung ist deutlich reduziert. Damit ist weniger Aufwand für eine Funkentstörung nötig. Ein weiterer Vorteil, der aus Figur 3 nicht ersichtlich ist, ist die reduzierte Verlustleistung, die im ersten Widerstand R1 dissipiert wird. Ein unterer Grenzwert für die Rückwärtserholzeit von D1 kann aus Figur 2 abgelesen werden. Die Rückwärtserholzeit von D1 muss mindestens so lang sein wie die Periodendauer der Störschwingung, die sich nach dem Stand der Technik ergäbe. Bei Störschwingungen im MHz-Bereich folgt eine minimale Rückwärtserholzeit von D1 von einer Mikrosekunde.

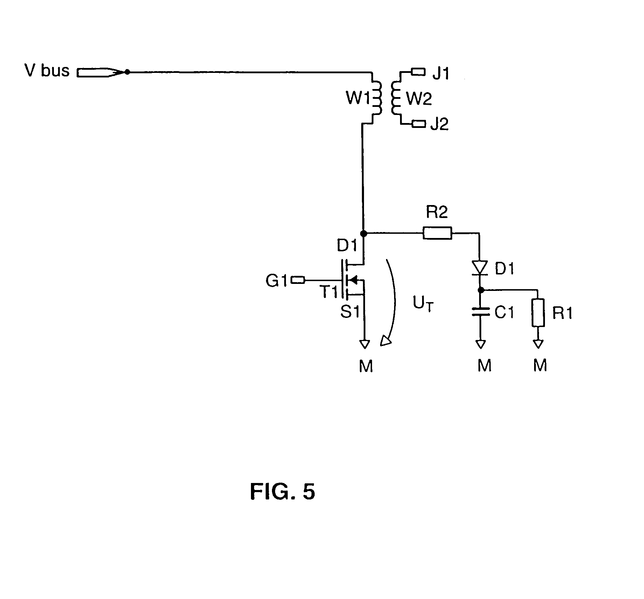

In Figur 4 ist ein weiteres erfindungsgemäßes Ausführungsbeispiel einer Leistungsversorgung dargestellt. Im Vergleich zu Figur 1 ist in Figur 4 der zweite elektronische Schalter als Bipolartransistor T2 ausgeführt. Die Schaltentlastungseinrichtung, die parallel zur Primärwicklung W1 geschaltet ist besteht aus dem Kondensator C1, dem Transistor T2 und dem Widerstand R3. Die Serienschaltung aus C1 und der Kollektor-Emitter-Strecke von T2 ist parallel zur Primärwicklung W 1 geschaltet. R3 ist parallel zur Basis-Emitter-Strecke von T2 geschaltet.

Im Vergleich zu Figur 1 ist in Figur 4 der Widerstand R1 entfallen. Die Funktion der Diode D1 wird von der Basis-Kollektor-Strecke von T2 übernommen. Der positive Strom der Primärwicklung W1 führt nach dem Abschalten von T1 über den Widerstand R3 und die Basis-Kollektor-Strecke von T2 und lädt somit C1. Die Rückwärtserholzeit der Diode D1 wird bei Einsatz eines Transistors T2 durch dessen Speicherzeit repräsentiert. Es muss also für T2 ein Transistor gewählt werden, dessen Speicherzeit der Rückwärtserholzeit einer erfindungsgemäß ausgelegten Diode entspricht. Ein negativer Strom in der Primärwicklung W1 kann während der Speicherzeit von T2 fließen. Wird anstatt einer Diode für den zweiten elektronischen Schalter ein Transistor eingesetzt, so wird vorteilhaft die Verlustleitung im zweiten elektronischen Schalter reduziert. Weiterhin vorteilhaft ist, dass mit dem Widerstand R3 die Speicherzeit von T2 eingestellt werden kann. Damit ist eine Justage der Zeit möglich, in der ein negativer Strom durch die Primärwicklung W1 fließt.

Es ist auch möglich, statt des Bipolartransistors für T2 einen MOSFET oder einen anderen elektronischen Schalter einzusetzen. Gegebenenfalls muss für diesen Schalter eine Ansteuerschaltung bereitgestellt werden, die den Schalter zu den gewünschten Zeiten öffnet und schließt. Er muss geschlossen werden, wenn der erste elektronische Schalter öffnet und er muss geöffnet werden, wenn der Kondensator C1 nach einem Ladevorgang wieder entladen ist. Spätestens muss der zweite elektronische Schalter jedoch dann geöffnet werden, wenn der erste elektronische Schalter wieder geschlossen wird.

In Figur 5 ist ein weiteres erfindungsgemäßes Ausführungsbeispiel einer Leistungsversorgung dargestellt. Im Vergleich zu den Figuren 1 und 4 ist die Schaltentlastungseinrichtung in Figur 5 nicht parallel zur Primärwicklung W1, sondern parallel zum ersten elektronischen Schalter T1 geschaltet. In Figur 5 besteht die Schaltentlastungseinrichtung aus der Serienschaltung eines Widerstands R2, einer Diode D1 und eines Kondensators C1. Parallel zu C1 ist ein Widerstand R1 geschaltet. Die Funktion dieser Bauelemente entspricht der Funktion der gleich bezeichneten Bauelementen in den anderen Figuren. Wie in Figur 4 kann die Diode D1 in Figur 5 auch durch einen Transistor ersetzt werden.

Für eine Wechselstrombetrachtung ist die Kopplung der Schaltentlastungseinrichtung mit dem Anschluss Vbus gleichwirkend wie die Kopplung mit dem Bezugspotenzial M. Dies hat die Speisegleichspannung, die zwischen die Anschlüsse Vbus und M angeschlossen ist, zur Folge, da sie für Wechselströme als Kurzschluss wirkt. Der Spannungsanstieg an den Arbeitsanschlüssen von T1 während des Ausschaltvorgangs kann beim Ausführungsbeispiel in Figur 5 vorteilhaft abgeflacht werden. Auch die Gestaltung eines Layouts kann für das eine oder andere Ausführungsbeispiel einfacher sein.

## Patentansprüche

1. Leistungsversorgung mit folgenden Merkmalen:
• ein erster und ein zweiter Energieeinspeisepunkt (Vbus, M),
• ein Transformator (TX1) mit einer Primär (W1)- und einer Sekundärwicklung (W2), wobei die Sekundärwicklung mit einer Last verbindbar ist,
• ein erster elektronischer Schalter (T1), der in Serie zur Primärwicklung (W1) geschaltet ist,
• die Serienschaltung aus dem ersten elektronischen Schalter (T1) und der Primärwicklung (W1) ist mit dem ersten und dem zweiten Energieeinspeisepunkt (Vbus, M) gekoppelt,
• eine parallel zur Primärwicklung (W1) oder parallel zum ersten elektronischen Schalter (T1) geschaltete Schaltentlastungseinrichtung, die die Serienschaltung eines Kondensators (C1) und eines zweiten elektronischen Schalters (D1, T2) enthält,
• die Serienschaltung des Kondensators (C1) und des zweiten elektronischen Schalters (D1, T2) bewirkt, dass die Energie, die beim Abschalten des ersten elektronischen Schalters (T1) durch den Strom in der Primärwicklung (W 1) repräsentiert wird, zumindest teilweise vom Kondensator (C1) aufgenommen wird,
**dadurch gekennzeichnet, dass**
der zweite elektronische Schalter (D1, T2) bewirkt, dass ein wesentlicher Teil der vom Kondensator (C1) aufgenommenen Energie in den Transformator (TX1) zurückgespeist wird.

2. Leistungsversorgung gemäß Anspruch 1,
**dadurch gekennzeichnet, dass**
parallel zum Kondensator ein erster Widerstand (R1) geschaltet ist.

3. Leistungsversorgung gemäß Anspruch 1 oder 2,
**dadurch gekennzeichnet, dass**
in Serie zum zweiten elektronischen Schalter (D1, T2) ein zweiter Widerstand (R2) geschaltet ist.

4. Leistungsversorgung gemäß einem der obigen Ansprüche
**dadurch gekennzeichnet, dass**
eine Diode (D1) den zweiten elektronischen Schalter bildet, wobei die Diode (D1) eine Rückwärtserholzeit aufweist, die länger ist als die Zeit, die verstreicht, bis ein wesentlicher Teil der vom Kondensator(C1) aufgenommenen Energie in den Transformator (TX1) zurückgespeist wird.

5. Leistungsversorgung gemäß Anspruch 4
**dadurch gekennzeichnet, dass**
die Diode (D1) eine Rückwärtserholzeit von mindestens einer Mikrosekunde aufweist.

6. Leistungsversorgung gemäß einem der Ansprüche 1-3,
**dadurch gekennzeichnet, dass**
ein Bipolartransistor (T2) den zweiten elektronischen Schalter bildet, wobei der Bipolartransistor (T2) eine Speicherzeit aufweist, die länger ist als die Zeit, die verstreicht, bis ein wesentlicher Teil der vom Kondensator (C1) aufgenommenen Energie in den Transformator (TX1) zurückgespeist wird.

7. Leistungsversorgung gemäß Anspruch 6
**dadurch gekennzeichnet, dass**
der Bipolartransistor (T2) eine Speicherzeit von mindestens einer Mikrosekunde aufweist.

8. Leistungsversorgung gemäß Anspruch 6 oder 7
**dadurch gekennzeichnet, dass**
ein dritter Widerstand (R3) parallel zu einer Basis-Emitterstrecke des Bipolartransistors (T2) geschaltet ist.

9. Leistungsversorgung gemäß einem der obigen Ansprüche
**dadurch gekennzeichnet, dass**
Lichtquellen die Last bilden.

10. Leistungsversorgung gemäß einem der obigen Ansprüche
**dadurch gekennzeichnet, dass**
Leuchtdioden die Last bilden.
